# EUROPEAN PATENT SPECIFICATION

(11) **EP 3 022 995 B1**
(45) Date of publication and mention of the grant of the patent: **09.08.2017**
(21) Application number: 14752383.1
(22) Date of filing: 20.06.2014
(51) Int. Cl.: H05K 7/14, B29C 45/14

(54) **METHOD TO PRODUCE AN ELECTRONIC MEASURING, CONDITIONING AND REGULATING INSTRUMENT, AND ELECTRONIC INSTRUMENT THUS PRODUCED**
VERFAHREN ZUR HERSTELLUNG EINES ELEKTRONISCHEN MESS-, KONDITIONIERUNGS- UND REGELUNGSINSTRUMENTS UND DAMIT HERGESTELLTES ELEKTRONISCHES INSTRUMENT
PROCÉDÉ DE PRODUCTION D'UN INSTRUMENT ÉLECTRONIQUE DE MESURE, DE CONDITIONNEMENT ET DE RÉGULATION ET INSTRUMENT ÉLECTRONIQUE AINSI PRODUIT

(30) Priority: 19.07.2013 IT UD20130098
(43) Date of publication of application: 25.05.2016
(73) Proprietor: ELIWELL CONTROLS SRL CON UNICO SOCIO, 32010 PIEVE D'ALPAGO (BL) (IT)
(72) Inventor: CASTAGNA, Francesco, I-32100 Belluno (IT); SPARANO, Massimo, I-32100 Belluno (IT)
(74) Representative: Petraz, Gilberto Luigi
(86) International application number: PCT/IB2014/062480
(87) International publication number: WO 2015/008177

(56) References cited:
- JP-A- H0 643 813
- JP-A- H09 136 335
- JP-A- 2005 353 486
- JP-A- 2010 117 242

## Description

### FIELD OF THE INVENTION

The present invention concerns a method to produce an electronic measuring, conditioning and regulating instrument and the electronic instrument thus obtained.

The invention is applied in the field of production of electronic instruments suitable to be used as regulators and/or measurers in general, and in particular in the field of regulating and conditioning temperature, pressure and/or humidity.

Said instruments essentially comprise a front-piece with a display unit and setting and command means, and a box-like container, with means to interface and connect to the outside, which houses within it the necessary components for the functioning of the instrument.

The invention offers an economical, rational and versatile solution to problems relating to the production of a range of instruments that are different in size and performance. Document JP H06 43813 discloses a method of producing an electronic instrument which comprises the method steps of the preamble of claim 1.

### BACKGROUND OF THE INVENTION

Instruments of the electronic type are known, used to measure and condition the parameters of a room, for example its temperature and humidity, or of a cooling unit, a heating plant or other.

Such instruments are normally applied in a panel, in a suitable hole or aperture, making the front-piece protrude in which the display unit and the command and setting members are made.

Inside the hole or aperture the box-like container is positioned, inside which the electronic components needed for the functioning of the instrument are positioned, for feeding it, for connecting it to the external members that it manages and commands, and for possible interface with data acquisition and remote control means.

Traditional instruments of this type normally consist of one or more printed circuits (PCB, Printed Circuit Board) on which at least the components for feeding and powering the instrument are normally mounted, and the smart part of the instrument, that is, the microprocessor.

Electronic instruments of the type in question are known, in which the front-piece includes not only the display unit but also other user interface means, which allow the latter to interact with the instrument so as to set, program or verify its functioning or that of an apparatus to which it is possibly connected.

The other user interface means typically include keys, switches or other devices that can be driven by contact or pressure by the user.

It is known to use keys, switches or other devices (hereafter indicated only by the term "keys") of the capacitive type, that is, driven by a variation in the capacity of a sensitive member, such as an equivalent capacitor, following said contact or pressure.

Generally, the equivalent capacitor is defined by the series of a capacitor inside the instrument and an external capacitor. The internal capacitor is normally, in its turn, defined by the series of two other capacitors: the first has its plates represented by a conductor element connected to a PCB which in use is parallel to the front-piece, and by an interface surface of the key body and having, as dielectric, the key body itself; the second capacitor has as plates an interface surface of the key body and a contact surface of the front-piece and, as dielectric, the insulating material that makes up the portion of the front-piece corresponding to the contact surface itself. The external capacitor is normally defined by the closure of the lines of electric field of the contact surface, both directly toward a reference potential micro-controller, and also to earth and from earth toward said reference potential.

The key body cited above is typically interposed between the conductor element and the front-piece, also functioning as a spacer, and is made of polymer material, for example a plastic or silicone rubber.

In order to increase the equivalent capacity of the internal capacitor and hence to make the resulting capacity of the series between the internal capacitor and the external capacitor depend exclusively on external perturbations of the capacity of the latter, typically the key body is made of a conductive polymer material obtained for example by doping a basic polymer material with particles of graphite or metal. In this way, the first of the two capacitors, internal in series, is bypassed by a conductor body and consequently the capacity of the internal capacitor increases so as to coincide with the second capacitor of the series.

The external perturbations, intended to increase the value of the resultant capacity cited above, can be for example the proximity or contact with the external surface of the front-piece by an external body. Varying the capacity of the equivalent capacitor causes the respective key to be driven.

It is also known to use intermediate spacers between the viewer and the PCB parallel to the front-piece, which spacers normally cooperate with lighting devices of the viewer, positioned on the PCB as above. The spacers typically cannot be made with conductive material, otherwise short circuits may be caused on the PCB between the electric and electronic components present therein, unless particular insulation strategies are adopted for said electric and electronic components.

This therefore entails the need for another operating step in the production of the electronic instrument, since the spacers and the key-bodies must necessarily be made at different moments in time.

It is also known to apply a sealing element, typically an annular packing, to the aperture in which the electronic instrument is to be inserted. This application is carried out in a dedicated operating step which takes place immediately before the instrument is housed in the aperture and attached to the panel.

The function of the sealing element is to prevent the access of liquids and/or dust from the front side of the panel, which is accessible to the user, to the rear side of the panel, on which side there are the electric connections of the electronic instrument.

One disadvantage of known electronic instruments is that positioning the spacers requires specific and precise operations to attach them to the respective conductor elements. Apart from determining per se an increase in the times and costs of producing the electronic instruments, this also has the consequence that it requires particular conformations, and hence workings, of the spacers and the conductor elements, with a negative effect on the times and costs of producing the electronic instruments.

The higher the possibility of oxidation of the conductor element with which the key body is coupled, the greater the accuracy of the reciprocal positioning of the various elements must be.

This situation requires a precise positioning of the key body on the conductor element, so as to exactly cover its surface, without invading the adjoining areas of the PCB, causing unwanted capacitive couplings.

Furthermore, in more serious cases, oxidation remains a problem despite the accuracy of the positioning of the key body on the conductive platen, for example when the key body is not perfectly impermeable to air and/or is made of material such as to trigger oxidation reactions on contact with the metal that makes up the conductor element.

Another disadvantage of known electronic instruments is that, in order to insulate the corresponding sensitive members, separate steps are required to assemble and position the sealing elements, which further affects production times and costs.

One purpose of the present invention is to perfect a method and produce an electronic instrument of the type described above where production times and costs are reduced, where the incidence of inaccuracies and production defects, and hence the discard of pieces, is limited.

Another purpose is to guarantee great standardization of the products obtained, and at the same time to increase their reliability compared with known products.

The Applicant has devised and embodied the present invention to overcome these shortcomings and to obtain other advantages as shown hereafter.

### SUMMARY OF THE INVENTION

The present invention is set forth and characterized in the independent claims, while the dependent claims describe variants to the main inventive idea.

In accordance with the above purposes, a method is supplied to produce an electronic measuring, conditioning and regulating instrument conventionally provided with at least a display front-piece with a viewer, one or more setting and command keys, and an electronic card with a part associated with the front-piece and disposed, during use, substantially parallel and in proximity thereto.

The method comprises at least a step of preparing the electronic card in which at least one or more light emission devices and electric components comprising at least one conductive platen are prepared on a surface of a PCB, and a step of positioning the PCB in which it is associated with the front-piece and located substantially parallel and in proximity to the latter.

According to a characteristic aspect of the present invention, the method also comprises a simultaneous production step of main bodies of the one or more keys, an optical screening element configured to prevent the overlapping of the light emitted by contiguous light emission devices, and a perimeter sealing element associated with an external perimeter edge of said front-piece.

The simultaneous production provides, in particular, the simultaneous overmolding or over-injection on the front-piece of the main bodies, of the optical screening conveyor element and the perimeter sealing element.

In this way the advantage is obtained of being able to make and assemble the three components described above in a single operating pass, thus reducing production times and costs of the electronic measuring, conditioning and regulating instrument. In the state of the art, at least two distinct operating passes are required.

A further advantage lies in the fact that, according to one aspect of the invention, the simultaneous production of the main bodies, the optical screening element and the perimeter sealing element can be carried out at the same time and parallel with respect to the step of making the electronic card. In the state of the art this is not possible, since at least the assembly of the first two components provides the direct connection thereof on the PCB and this therefore must take place at the end of the production of the latter.

In some forms of embodiment, the simultaneous production step cited above provides to make a series of through channels in the optical screening element, each configured to house protuberances protruding from the front-piece with the function of conveying the light of the light emission devices toward the viewer.

According to some aspects, the simultaneous production step provides to make the optical screening conveyor element and the main bodies as portions of a single body.

In possible implementations, the step of preparing the electronic card provides to integrate the conductive platens in the PCB and to paint them, during the production step of the PCB, by means of depositing on them a layer of insulating paint. The insulating paint is chosen from a group comprising polymer materials such as at least a photopolymer, an epoxy or epoxy acrylic resin and the "solder-resist" typically used in the production process of PCBs.

The paint cited above has the advantage of allowing to eliminate the problems of oxidization of the conductive platens to which the main bodies of the keys are coupled and consequently to be able to reduce the criticality in the relative positioning of the main bodies on the conductive platens. Consequently this allows to make the tolerances in the overmolding/over-injection of the main bodies on the front-piece less critical.

Moreover, the layer of paint on top of each conductive platen, being equivalent to a capacitive element with a high capacity located in series with respect to the main body and to the front-piece, does not influence the functioning of the corresponding key.

The present invention also concerns an electronic measuring, conditioning and regulating instrument produced with a method as described above.

### BRIEF DESCRIPTION OF THE DRAWINGS

These and other characteristics of the present invention will become apparent from reading the preferential form of embodiment of the invention, taken with reference to the attached drawings wherein:
- fig. 1 is a three-dimensional view of an electronic measuring, conditioning and regulating instrument in which the present invention is used;
- fig. 2 shows a three-dimensional and exploded view of the electronic instrument in fig. 1;
- fig. 3 shows a three-dimensional rear view of the electronic instrument in fig. 2;
- fig. 4 shows an assembly step of some forms of embodiment of the electronic instrument.

To facilitate comprehension, the same reference numbers have been used, where possible, to identify identical common elements in the drawings.

### DETAILED DESCRIPTION OF SOME FORMS OF EMBODIMENT

We shall now refer in detail to the various forms of embodiment of the present invention, of which one or more examples are shown in the attached drawing. Each example is supplied by way of illustration of the invention and shall not be understood as a limitation thereof. For example, the characteristics shown or described insomuch as they are part of one form of embodiment can be adopted on, or in association with, other forms of embodiment to produce another form of embodiment. It is understood that the present invention shall include all such modifications and variants.

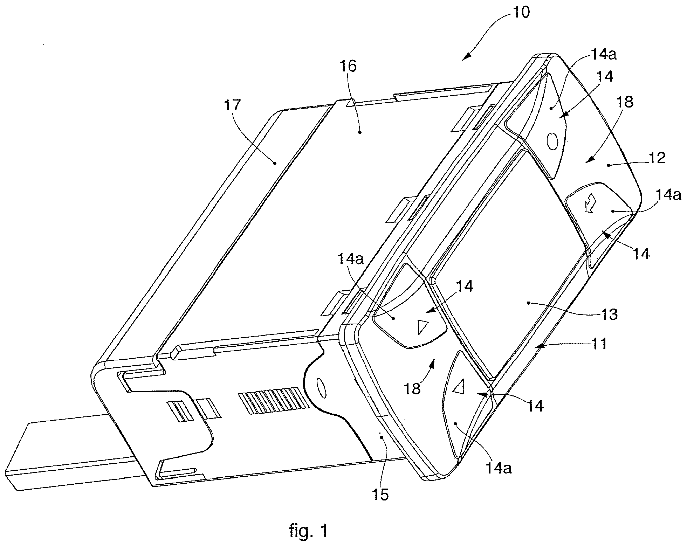

Fig. 1 is used to describe forms of embodiment of an electronic measuring, conditioning and regulating instrument according to the present invention, indicated in its entirety by the reference number 10.

The electronic instrument 10 is provided in this case with a front-piece 11 that includes a front mask 12, which defines a viewer 13 of the display unit, and keys 14, which are part of a setting and command unit 18 of the capacitive type.

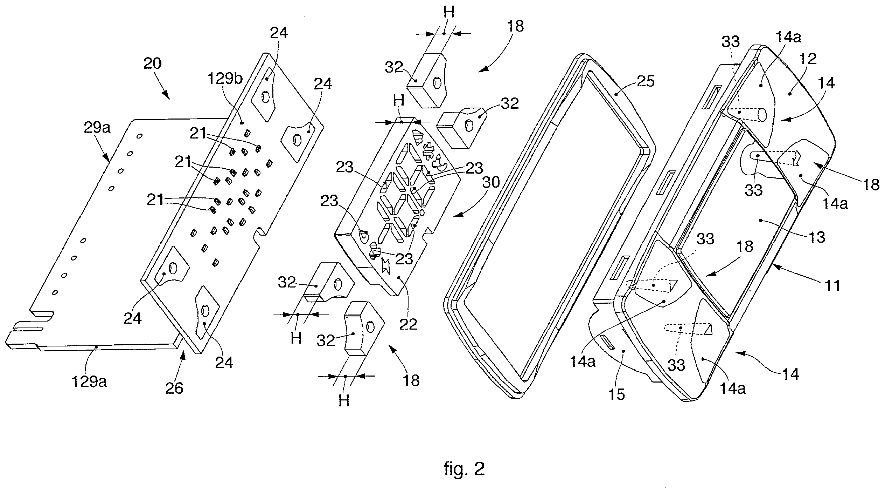

The keys 14 can be provided with a contact portion 14a made directly in the front mask 12, as shown by way of example in fig. 2.

Moreover, the front-piece 11 can provide, on its rear part, a containing wall 15 which can have variable length or depth depending on the use of the electronic instrument 10.

According to some forms of embodiment, the electronic instrument 10 comprises a box-like container 16 of a typically parallelepiped shape, closed at the rear, in the specific case shown merely by way of example, by a protection cap 17, intended to supply a protective closing of the box-like container 16.

Simplified forms of embodiment can provide to adopt only the box-like container 16, without the protection cap 17.

The assembly of the front-piece 11 and the box-like container 16, and possibly the protection cap 17, can be achieved in any known way, for example by simple interference, by fixed joint, using pegs, tongues, pins, or in any other way; this is irrelevant for the purposes of the present invention.

For example, the front-piece 11 can connect to the box-like container 16 by means of the containing walls 15, to define the electronic instrument 10 in its entirety.

A perimeter sealing element, such as for example an annular packing 25, can be provided around the external perimeter edge of the front-piece 11 to insulate and protect the electronic instrument 10 once installed, for example on a panel, on a domestic appliance or on an industrial conditioning apparatus.

In particular, the annular packing 25 is intended to seal the aperture in which the electronic instrument 10 is installed, and to prevent the passage of liquids and/or dust or other bodies from the front side to the rear side of the installation panel.

With reference to fig. 2, which shows an exploded view of the electronic instrument 10 to show the components of its forms of embodiment in detail, inside the box-like container 16 and in part of the front-piece 11 an electronic card 20 is housed that includes the necessary components for the functioning of the electronic instrument 10 and the execution of its functions.

In the specific cases described with reference to the attached drawings, non-restrictive of the scope of the present invention, the electronic card 20 consists of a first part 29a, which includes a first printed circuit, or first PCB 129a, and a second part 29b which includes a second printed circuit, or second PCB 129b.

The first part 29a and the second part 29b are reciprocally connected or mechanically constrained in correspondence to a connection zone 26 between the first PCB 129a and the second PCB 129b, for example by welding or other type of connection suitable to the purpose.

The same considerations which will be made hereafter in the description are valid both for forms of embodiment of electronic instruments 10 in which the electronic card 20 is made as in the attached drawings, and also for forms of embodiment in which it includes only the second part 29b.

Such considerations are also valid for forms of embodiment in which the electronic instruments 10 are provided with a plurality of printed circuits, one of which coincides with the second PCB 129b of the second part 29b.

As shown in fig. 2, once all the components have been assembled both on the first PCB 129a and on the second PCB 129b, parts 29a and 29b can be located at 90° with respect to each other, to define the clamping of the printed circuits to be inserted in the containing part defined by the possible containing wall 15, by the box-like container 16 and possibly by the protection cap 17.

The assembly operation of the electronic card 20 concludes by inserting the latter with its first part 29a disposed, during use, substantially horizontal inside the box-like container 16 and its second part 29b, on whose respective second PCB 129b electric and electronic components intended for the display are mounted, disposed during use substantially vertical and parallel, facing and in proximity to the viewer 13 of the front-piece 11.

In some forms of embodiment, the second part 29b can be positioned inside the front mask 12.

The front-piece 11 can connect to the box-like container 16 by means of the containing walls 15, to define the electronic instrument 10 in its entirety.

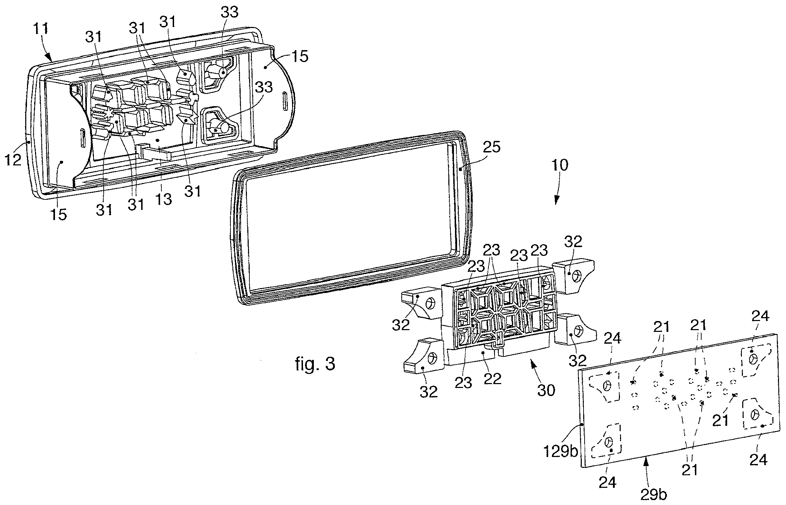

Figs. 2 and 3 also show, merely as an example of possible electronic components destined for the display, light emission devices such as light emission diodes, or LEDs 21, associated with the surface of the second PCB 129b facing toward the viewer 13 of the front-piece 11, for example by means of Surface-Mount Technology, or SMT.

This technique allows to reduce, simplify and accelerate the assembly and mounting methods of the components on the PCB.

With reference to figs. 2 to 4, the electronic instrument 10 can also include a spacer unit 30 interposed between the second part 29b of the electronic card 20 and the front-piece 11, in correspondence to the viewer 13.

The function of the spacer unit 30 is to keep the second PCB 129b and the viewer 13 at a determinate reciprocal distance.

The spacer unit 30 can include an optical screening element 22 and one or more main bodies 32 of the keys 14.

The optical screening element 22 is configured to prevent the overlapping of the light emitted by adjacent LEDs 21, which overlapping is also known in the field as "cross-talk".

To this purpose, the optical screening element 22 can be made of an opaque material, preferably a dark color, for example black in the case of LEDs 21 with red light emission, and can be provided with through channels 23.

These are independent from each other, that is, they do not communicate with each other and each acts as a containing channel of the light of a single LED 21, or a group of LEDs 21.

In particular, the optical screening element 22 is positioned in contact with the second PCB 129b and with the internal part of the front-piece 11 in correspondence with the viewer 13, so that each through channel 23 has one end surrounding a LED 21, or a group of LEDs 21, and one end, opposite the previous one, open toward the viewer 13.

The opaque material that the optical screening element 22 is made of can be a polymer material, for example a plastic or a rubber, such as flexible silicone rubber, or a natural rubber, such as caoutchouc.

Preferably, the material that the optical screening element 22 is made of is not conductive, in order to prevent the onset of electric short circuits between the feed conductors of the LEDs 21, and to electrically insulate the front-piece 11 from the second part 29b.

The optical screening element 22 also has the function of a spacer between the second part 29b and the viewer 13.

Fig. 3 can be used to describe forms of embodiment in which the front-piece 11 can include, in correspondence with the viewer 13, one or more protuberances 31 protruding from the front mask 12 toward the second part 29b.

In some forms of embodiment, the protuberances 31 are equal in number to the through channels 23 of the optical screening element 22.

The protuberances 31 can each act as a light wave guide for the light emitted by a LED 21 toward the viewer 13.

In possible implementations, it is possible to provide that a protuberance 31 acts as a light wave guide for the light emitted by a group of LEDs 21.

Each protuberance 31 is configured to be housed in a corresponding through channel 23 of the screening element 22 in order to fill it substantially completely, and it protrudes until it reaches near the mating LED 21, or mating LEDs 21.

In some forms of embodiment, each protuberance 31 can be made in a piece with the front mask 12, for example in a single molding operation, or can be applied thereto with an integration operation after the front mask 12 has been made.

With a view to reducing production costs and times of the electronic instrument 10, the first solution is preferable, which implies making a single mold and performing a single molding operation.

In possible forms of embodiment, as shown in figs. 2 and 3, protuberances 33 can be provided in correspondence with the keys 14 with the function of wave guides for the rear lighting thereof.

One or more conductive platens 24 can be connected to the second part 29b, each in substantial correspondence with the position of one of the keys 14.

The conductive platens 24 can be applied on the second PCB 129b, using glue for example, or screen printing, or by a fixed joint connection, or they can be integrated in it. Each conductive platen 24 can be only a few micrometers thick, for example in the case where it is defined by a metal coating of the second PCB 129b.

In some forms of embodiment, the conductive platens 24 are covered, or painted, with a layer of insulating paint, like a non-conductive polymer material, for example an epoxy or epoxy-acrylic resin, in order to limit the oxidation process. This painting, however, does not alter the functioning of the keys 14.

It is also possible to use, as an insulating paint for coating the conductive platens 24, the "solder-resist" typically used in the construction steps of the second PCB 129b for the reciprocal insulation of conductive parts, in order to reduce the adhesion of welding material in zones of the second PCB 129b where it is not desired, and to protect the components integrated into the second PCB 129b from welding offcuts.

This solution is advantageous especially when the conductive platens 24 are integrated in the second PCB 129b, because it advantageously allows to avoid introducing a dedicated painting step, which would cause increases in the production costs.

Figs. 2 to 4 are used to describe forms of embodiment of the electronic instrument 10 in which each key 14 includes a main body 32, positioned between its contact portion 14a and the conductive platen 24.

In possible implementations, each main body 32 is in contact with both the conductive platen 24 and the contact portion 14a.

Each main body 32 contributes to the equivalent capacity of the internal capacitor of the electronic instrument 10.

In some forms of embodiment, the main bodies 32 can be made of an electrically insulating material, that is, non-conductive.

In possible forms of embodiment, the material also has a high dielectric constant, that is, a value higher than 4, the typical value of conventional polymer materials.

The electrically insulating material can be a rubber, natural or synthetic, for example caoutchouc or silicone, or a polymer foam, for example polyurethane or polystyrene foam, or another polymer material, such as a polyester, a polyamide or other similar insulating materials.

In alternative forms of embodiment, the main bodies 32 of the keys 14 are made of conductive plastic or rubber, for example containing metal or graphite particles.

One advantage of painting the conductive platens 24 with insulating paint, and particularly relevant in the forms of embodiment where the main bodies 32 are made of conductive material, is the increase in insulation between the front-piece 11 of the electronic instrument 10 and the second part 29b of the electronic card 20. This is due in particular to the fact that the main body 32 of each key 14 in this way is not electrically connected to the conductive platen 24 due to the effect of the layer of insulating paint interposed.

In some forms of embodiment, the material used for the main bodies 32 is a highly-flexible plastic or rubber, so that it can be deformed by the pressure, even slight, exerted by a user on the contact portion 14a of the keys 14.

In possible implementations, the same material can be used to make both the annular packing 25 and the optical screening element 22, and the main bodies 32 of the keys 14.

In this way, the same production techniques can be used to obtain the above three components, which therefore can be worked and produced in a single operating step, for example a single molding operation.

These forms of embodiment are to be considered preferential with a view to containing production costs of the electronic instrument 10.

In some forms of embodiment, described with reference to the attached drawings, and for the same reason as described above, the main bodies 32 and the optical screening element 22 can have essentially the same thickness H.

In some implementations, local variations in the thickness H of the spacer unit 30 can be provided, for example in correspondence with the main bodies 32 of the keys 14, to guarantee that they come into contact with the respective conductive platens 24.

Furthermore, such variations can be intended to prevent the formation of layers of air between the main bodies 32 and the corresponding conductive platens 24.

This allows to obtain a spacer unit 30 that is substantially parallelepiped, and also to simplify the geometry and hence make the front mask 12 and the second part 29b of the electronic card 20 easier and cheaper to make. In fact, the electronic card 20 can include a single, flat PCB 129b.

In possible implementations, the main bodies 32 and the optical screening element 22 are made in a single piece.

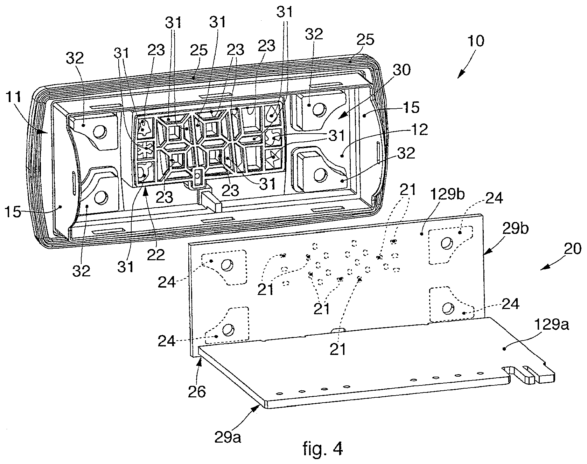

Fig. 4 shows forms of embodiment in which the main bodies 32 and the optical screening element 22, that is, the spacer unit 30, are made, for example by over-injection or overmolding, directly on the internal part of the front-piece 11.

The subsequent assembly provides that the optical screening element 22 covers the LEDs 21, including them in its through channels 23, and the main bodies 32 are superimposed over the conductive platens 24.

Advantageously, with a view to containing the costs and times of making the electronic instrument 10, the optical screening element 22 and the main bodies 32 can be connected with a single operation of overmolding or over-injection on the internal surface of the front-piece 11.

In this single operation, the components of the spacer unit 30 are made simultaneously, and at the same time the protuberances 31 and the through channels 23 are coupled. The coupling occurs during over-injection, when the injected material of the spacer unit 30 surrounds the protuberances 31, which substantially function as negative molds for making the through channels 23.

In forms of embodiment where the conductive platens 24 are coated with a thin layer of insulating paint, the painting allows to eliminate the problems of oxidation of the conductive platens 24 with which the main bodies 32 of the keys 14 are coupled, and consequently to render the tolerances less critical in the process of overmolding/over-injection of the main bodies 32 on the front-piece 11.

In this way, moreover, it is possible to reduce the criticality due to the precision of the relative positioning of the main bodies 32 on the corresponding conductive platens 24.

Fig. 4 is used to describe forms of embodiment in which, apart from the reduction in costs and faster production as described above, a reduction is also obtained in the assembly times of the electronic instruments 10.

In fact, fig. 4 shows a rear view of a part of the electronic instrument 10 to illustrate the fact that the optical screening element 22, the main bodies 32 of the keys 14 and the annular packing 25 are made in a single operating pass, and assembled on the front-piece 11 in the same operating pass.

The single operating pass provides the simultaneous overmolding or the simultaneous over-injection of said components with the front-piece 11.

In particular, the main bodies 32 of the keys 14 and the optical screening element 22 are overmolded or over-injected in the rear of the front-piece 11, while the annular packing 25 is produced directly on or astride the perimeter edge of the front-piece 11.

The method to make the electronic instrument 10 provides to make the electronic card 20 as described above, including the operations to mount and assemble electric components such as the conductive platens 24, and electronic components such as the LEDs 21, on a surface of the second PCB 129b.

Parallel to the making of the electronic card 20, at the same time the main bodies 32 of the keys 14, the optical screening element 22 and the annular packing 25 are overmolded or over-injected on the front-piece 11.

Some forms of embodiment of the electronic instrument 10 provide that the overmolding or over-injection operation is performed before or after the electronic card 20 is made.

Afterward, once the electronic card 20, the main bodies 32, the optical screening element 22 and the annular packing 25 have been made, the operation to assemble the electronic card 20 is concluded by inserting it inside the box-like container 16.

In particular, the electronic card 20 is inserted into the box-like container 16 with its first part 29a disposed during use substantially horizontal, and its second part 29b, provided with electric and electronic components intended for the display, disposed during use substantially vertical and parallel, facing and in proximity to the viewer 13 of the front-piece 11.

In some forms of embodiment, the second part 29b can be positioned inside the front-piece 11 and it may be provided that the main bodies 32 of the keys 14 are put in contact with the conductive platens 24.

In possible implementations, which can be combined with the forms of embodiment described above, the step of preparing the electronic card 20 may provide to integrate the conductive platens 24 in the second PCB 129b, and to paint it, during the production step thereof, which provides to deposit an insulating paint, such as for example the solder-resist commonly used in the PCB production process.

Such painting, which allows to obviate problems of oxidation of the conductive platens 24, does not compromise the functioning of the keys 14.

Adopting a layer of paint is electrically equivalent to introducing a capacitive element, associated with the layer of paint, in the series of two capacitive elements defined by the main body 32 and the contact portion 14a, which make up the equivalent internal capacity. The capacitive effect of the layer of paint is however irrelevant, since it is of negligible thickness compared to the thickness H of the main body 32 and the thickness of the contact portion 14a.

Furthermore, the layer of insulating paint has a surface equal to the conductive platen and therefore a capacitive value much greater than that of the two components mentioned above. Consequently, the layer of paint has a negligible effect in the contribution to the value of the equivalent internal capacity.

It should also be noted that the painting is applicable both in the case of main bodies 32 made of insulating material, and also in the case of conductive materials, since in both cases there is at least a pre-existing internal capacitive element, defined by the contact portion 14a, to which the higher-value capacitive element associated to the thin layer of paint finds itself equivalently connected in series.

It is clear that modifications and/or additions of parts may be made to the method to produce an electronic measuring, conditioning and regulating instrument as described heretofore, without departing from the field and scope of the present invention.

It is also clear that, although the present invention has been described with reference to some specific examples, a person of skill in the art shall certainly be able to achieve many other equivalent forms of production method, having the characteristics as set forth in the claims and hence all coming within the field of protection defined thereby.

## Claims

1. Method to produce an electronic measuring, conditioning and regulating instrument provided with at least a display front-piece (11) having a viewer (13), with one or more setting and command keys (14), and with an electronic card (20) having a part (29b) associated with said front-piece (11) and disposed substantially parallel and in proximity to the latter, comprising a step of preparing said electronic card (20) in which at least one or more light emission devices (21) and electric components comprising one or more conductive platens (24) are mounted on a surface of a PCB (129b), and a step of positioning said PCB (129b) associated with the front-piece (11) and substantially parallel and in proximity to the latter, **characterized in that** it also comprises a simultaneous production step of main bodies (32) of said one or more keys (14), an optical screening element (22) of the light emitted by said light emission devices (21) toward said viewer (13), a perimeter sealing element (25) associated with an external perimeter edge of said front-piece (11), said simultaneous production providing the simultaneous overmolding or over-injection on said front-piece (11) of said main bodies (32), said optical screening element (22) and said perimeter sealing element (25).

2. Method as in claim 1, **characterized in that** said simultaneous production step is carried out before or after the step of preparing said electronic card (20).

3. Method as in claim 1, **characterized in that** said simultaneous production step is carried out parallel and simultaneously to the step of preparing said electronic card (20).

4. Method as in any claim from 1 to 3, **characterized in that** said simultaneous production step provides to make one or more through channels (23) in said optical screening element (22), each configured to convey the light emitted by one or more of said light emission devices (21).

5. Method as in any claim from 1 to 4, **characterized in that** said step of positioning the PCB (129b) is carried out after said simultaneous production step and provides to position the light emission devices (21) in correspondence to the optical screening element (22) and the conductive platens (24), each in contact with one of said main bodies (32) of the one or more keys (14).

6. Method as in any claim from 1 to 5, **characterized in that** said simultaneous production step provides to make at least said optical screening element (22) and the main bodies (32) of the same polymer material.

7. Method as in any claim from 1 to 6, **characterized in that** said simultaneous production step provides to obtain an optical screening element (22) and main bodies (32) essentially having the same thickness (H).

8. Method as in any claim from 1 to 7, **characterized in that** said preparation step of the electronic card (20) provides to integrate said one or more conductive platens (24) in the PCB (129b) and to carry out the painting of said one or more conductive platens (24), during the production step of said PCB (129b), by depositing a layer of insulating paint.

9. Electronic measuring, conditioning and regulating instrument, provided with at least a display front-piece (11) having a viewer (13), one or more setting and command keys (14), and an electronic card (20) having a part (29b) associated with the front-piece (11) and disposed, during use, substantially parallel and in proximity thereto, said part (29b) comprising at least one or more light emission devices (21) and electric components comprising one or more conductive platens (24) mounted on the surface of or integrated in a PCB (129b), said electronic instrument being made using a method as in any claim hereinbefore, **characterized in that** it comprises main bodies (32) of said one or more keys (14), an optical screening element (22) of the light emitted by said light emission devices (21) toward said viewer (13), and a perimeter sealing element (25) associated with an external perimeter edge of said front-piece (11) made simultaneously by means of overmolding or over-injection on said front-piece (11).

10. Electronic instrument as in claim 9, **characterized in that** said main bodies (32) and said optical screening element (22) define portions of a single body.

11. Electronic instrument as in claim 9 or 10, **characterized in that** said conductive platens (24) are integrated in said PCB (129b) and are covered by a layer of insulating paint.

## Patentansprüche

1. Verfahren zum Herstellen eines elektronischen Mess-, Aufbereitungs- und Regelungsinstrumentes, das mit mindestens einem Display-Frontelement (11) versehen ist, das ein Betrachtungsgerät (13) hat, mit einem oder mehreren Einstellungs- und Befehlstasten (14) und mit einer elektronischen Karte (20), die ein Teil (29b) hat, das mit dem Frontelement (11) verbunden ist und im Wesentlichen parallel zu und in der Nähe des letzteren angeordnet ist, das einen Schritt des Herstellens der elektronischen Karte (20) umfasst, in der mindestens ein oder mehrere lichtemittierende Vorrichtungen (21) und elektrische Komponenten, die einen oder mehrere leitfähige Träger (24) umfassen, auf einer Oberfläche einer Leiterplatte (129b) befestigt sind, und ein Schritt des Positionierens der Leiterplatte (129b), die mit dem Frontelement (11) verbunden ist und im Wesentlichen parallel und in der Nähe der letzteren ist, **dadurch gekennzeichnet, dass** es auch einen simultanen Herstellungsschritt von Hauptkörpern (32) von den einen oder mehreren Tasten (14), einem optischen Abtastelement (22) für das Licht, das von den lichtemittierenden Vorrichtungen (21) zu dem Betrachtungsgerät (13) emittiert wird, einem Umfangsdichtungselement (25) umfasst, das mit einer externen Umfangskante des Frontelementes (11) verbunden ist, wobei die gleichzeitige Herstellung für ein simultanes Überspritzen oder Aufspritzen auf dem Frontelement (11) der Hauptkörper (32), des optischen Abtastelementes (22) und des Umfangsdichtungselementes (25) sorgt.

2. Verfahren nach Anspruch 1, **dadurch gekennzeichnet, dass** der simultane Herstellungsschritt vor oder nach dem Schritt der Herstellung der elektronischen Karte (20) ausgeführt wird.

3. Verfahren nach Anspruch 1, **dadurch gekennzeichnet, dass** der simultane Herstellungsschritt parallel zu und simultan zum Schritt der Herstellung der elektronischen Karte (20) ausgeführt wird.

4. Verfahren nach einem der Ansprüche 1 bis 3, **dadurch gekennzeichnet, dass** der simultane Herstellungsschritt vorsieht, einen oder mehrere Durchgangskanäle (23) im optischen Abtastelement (22) herzustellen, wobei jeder dafür ausgelegt ist, das Licht weiterzuleiten, das von einer oder mehreren der lichtemittierenden Vorrichtungen (21) emittiert wird.

5. Verfahren nach einem der Ansprüche 1 bis 4, **dadurch gekennzeichnet, dass** der Schritt des Positionierens der Leiterplatte (129b) nach dem simultanen Herstellungsschritt ausgeführt wird und vorsieht, die lichtemittierenden Vorrichtungen (21) entsprechend dem optischen Abtastelement (22) und den leitfähigen Trägern (24) zu positionieren, jedes in Kontakt mit einem der Hauptkörper (32) der einen oder mehr Tasten (14).

6. Verfahren nach einem der Ansprüche 1 bis 5, **dadurch gekennzeichnet, dass** der simultane Herstellungsschritt vorsieht, zumindest das optische Abtastelement (22) und die Hauptkörper (32) aus demselben Polymermaterial herzustellen.

7. Verfahren nach einem der Ansprüche 1 bis 6, **dadurch gekennzeichnet, dass** der simultane Herstellungsschritt vorsieht, dass ein optisches Abtastelement (22) und die Hauptkörper (32) im Wesentlichen dieselbe Dicke (H) haben.

8. Verfahren nach einem der Ansprüche 1 bis 7, **dadurch gekennzeichnet, dass** der Anfertigungsschritt für die elektronische Karte (20) vorsieht, einen oder mehrere leitfähige Träger (24) in die Leiterplatte (129b) zu integrieren und das Beschichten des einen oder der mehreren leitfähigen Träger (24) während des Herstellungsschritts der Leiterplatte (129b) durch Auftragen einer Schicht von Isolierfarbe vorzunehmen.

9. Elektronisches Mess-, Konditionierungs- und Regelungsinstrument, das mit mindestens einem Display-Frontelement (11) versehen ist, das ein Betrachtungsgerät (13), eine oder mehrere Einstellungs- und Befehlstasten (14) und eine elektronische Karte (20) hat, die ein Teil (29b) hat, das mit dem Frontelement (11) verbunden und während der Verwendung im Wesentlichen parallel dazu und in der Nähe desselben ist, wobei das Teil (29b) mindestens eine oder mehrere lichtemittierende Vorrichtungen (21) und elektrische Komponenten umfasst, die einen oder mehrere leitfähige Träger (24) umfassen, welche auf der Oberfläche einer Leiterplatte (129b) montiert oder in dieselbe integriert sind, wobei das elektronische Instrument unter Verwendung eines Verfahrens nach einem der vorher genannten Ansprüche hergestellt wird, **dadurch gekennzeichnet, dass** es Hauptkörper (32) der einen oder mehreren Tasten (14), ein optisches Abtastelement (22) für das Licht, das von den lichtemittierenden Vorrichtungen (21) zum Betrachtungsgerät (13) emittiert wird, und ein Umfangsdichtungselement (25) umfasst, das mit einer externen Umfangskante des Frontelementes (11) verbunden ist, das gleichzeitig mittels Umspritzen oder Überspritzen auf dem Frontelement (11) hergestellt wird.

10. Elektronisches Instrument nach Anspruch 9, **dadurch gekennzeichnet, dass** die Hauptkörper (32) und das optische Abtastelement (22) Teile eines einzigen Körpers definieren.

11. Elektronisches Instrument nach Anspruch 9 oder 10, **dadurch gekennzeichnet, dass** die leitfähigen Träger (24) in die Leiterplatte (129b) integriert und durch eine Schicht von Isolierfarbe abgedeckt sind.

## Revendications

1. Procédé de production d'un instrument électronique de mesure, de conditionnement et de régulation doté d'au moins une partie avant (11) d'affichage avec une visionneuse (13), pourvue d'une ou plusieurs touches de commande (14) et d'une carte (20) électronique, dont une partie (29b) est associée à ladite partie avant (11) et se trouve parallèle à et à proximité de celle-ci, comprenant une étape consistant à préparer ladite carte (20) électronique, dans laquelle au moins un ou plusieurs dispositifs (21) électroluminescents et des éléments électriques comprenant une ou plusieurs plaques (24) conductrices sont montés sur une surface d'une carte (129b) de circuit imprimé et une étape consistant à positionner ladite carte (129b) de circuit imprimé associée à la partie avant (11) et sensiblement parallèle à et à proximité de celle-ci, **caractérisé en ce qu'**il comprend également une étape de production simultanée de corps (32) principaux desdites une ou plusieurs touches (14), un élément (22) de filtrage optique de la lumière émise par lesdits dispositifs (21) électroluminescents vers ladite visionneuse (13), un élément (25) d'étanchéité de périmètre associé à un bord de périmètre externe de ladite partie avant (11), ladite production simultanée comportant un surmoulage ou une surinjection simultané sur ladite partie avant (11) desdits éléments principaux (32), ledit élément de filtrage optique (22) et ledit élément d'étanchéité de périmètre (25).

2. Procédé selon la revendication 1, **caractérisé en ce que** ladite étape de production simultanée est effectuée avant ou après l'étape de préparation de ladite carte (20) électronique.

3. Procédé selon la revendication 1, **caractérisé en ce que** ladite étape de production simultanée est effectuée en parallèle et simultanément avec l'étape de préparation de ladite carte (20) électronique.

4. Procédé selon n'importe laquelle des revendications 1 à 3, **caractérisé en ce que** ladite étape de production simultanée comporte la formation d'un ou plusieurs canaux (23) débouchants dans ledit élément (22) de filtrage optique, chacun desquels est conçu pour transporter la lumière émise par un ou plusieurs desdits dispositifs (21) électroluminescents.

5. Procédé selon importe laquelle des revendications 1 à 4, **caractérisé en ce que** ladite étape de positionnement de la carte (129b) de circuit imprimé est effectuée après ladite étape de production simultanée et comporte le positionnement des dispositifs (21) électroluminescents au niveau de l'élément (22) de filtrage optique et des plaques (24) conductrices, chacun en contact avec l'un desdits corps (32) principaux des une ou plusieurs touches (14).

6. Procédé selon n'importe laquelle des revendications 1 a 5, **caractérisé en ce que** ladite étape de production simultanée comporte la formation d'au moins ledit élément (22) de filtrage optique et des corps (32) principaux avec le même matériau polymère.

7. Procédé selon n'importe laquelle des revendications 1 a 6, **caractérisé en ce que** ladite étape de production simultanée comporte la réalisation d'un élément (22) de filtrage optique et de corps (32) principaux sensiblement avec la même épaisseur (H).

8. Procédé selon l'emporte laquelle des revendications 1 à 7, **caractérisé en ce que** ladite étape de préparation de la carte (20) électronique comporte l'intégration desdites une ou plusieurs plaques (24) conductrices dans la carte (129b) de circuit imprimé et le vernissage desdites une ou plusieurs plaques (24) conductrices, pendant l'étape de production de ladite carte (129b) de circuit imprimé, par le dépôt d'une couche de vernis isolant.

9. Instrument électronique de mesure, de conditionnement et de régulation doté d'au moins une partie avant (11) d'affichage avec une visionneuse (13), d'une ou plusieurs touches de commande (14) et d'une carte (20) électronique, dont une partie (29b) est associée à la partie avant (11) et se trouve, pendant l'emploi, sensiblement parallèle à et à proximité de celle-ci, ladite partie (29b) comprenant au moins un ou plusieurs dispositifs (21) électroluminescents et des éléments électriques comprenant une ou plusieurs plaques (24) conductrices montés sur la surface de ou intégrés dans une carte (129b) de circuit imprimé, ledit instrument électronique étant réalisé par un procédé selon n'importe laquelle des revendications précédentes, **caractérisé en ce qu'**il comprend des corps (32) principaux desdites une ou plusieurs touches (14), un élément (22) de filtrage optique de la lumière émise par lesdits dispositifs (21) électroluminescents vers ladite visionneuse (13), et un élément (25) d'étanchéité de périmètre associé à un bord de périmètre externe de ladite partie avant (11), réalisés simultanément par surmoulage ou surinjection sur ladite partie avant (11).

10. Instrument électronique selon la revendication 9, **caractérisé en ce que** lesdits corps (32) principaux et ledit élément (22) de filtrage optique définissent des parties d'un corps unique.

11. Instrument électronique selon la revendication 9 ou 10, **caractérisé en ce que** lesdites plaques (24) conductrices sont intégrées dans ladite carte (129b) de circuit imprimé et sont couvertes par une couche de vernis isolant.
